# EUROPEAN PATENT APPLICATION

(11) **EP 4 529 363 A1**
(43) Date of publication of application: **26.03.2025**
(21) Application number: 23807453.8
(22) Date of filing: 02.05.2023
(51) Int. Cl.: H05K 1/02, H01L 23/02, H01L 23/12

(54) **WIRING BOARD, ELECTRONIC COMPONENT MOUNTING PACKAGE USING WIRING BOARD, AND ELECTRONIC MODULE**

(30) Priority: 19.05.2022 JP 2022082404
(71) Applicant: Kyocera Corporation, Kyoto-shi, Kyoto 612-8501 (JP)
(72) Inventor: KON Tomoya, Kyoto-shi, Kyoto 612-8501 (JP)
(74) Representative: Viering, Jentschura & Partner mbB Patent- und Rechtsanwälte
(86) International application number: PCT/JP2023/017168
(87) International publication number: WO 2023/223846

(57) **Abstract**

A wiring board includes a first insulating layer, a second insulating layer, a conductor layer, a first ground conductor, and a second ground conductor. The conductor layer includes a pair of first signal lines and a pair of second signal lines extending in a first direction. The second ground conductor includes a pair of first openings and a pair of second openings. The second insulating layer includes a pair of first through-conductors, a pair of second through-conductors, and a middle through-conductor. Each first through-conductor of the pair of first through-conductors is positioned in a corresponding one of the pair of first openings and coupled to a corresponding one of the pair of first signal lines. Each second through-conductor of the pair of second through-conductors is positioned in a corresponding one of the pair of second openings and coupled to a corresponding one of the pair of second signal lines. The middle through-conductor is positioned between the pair of first openings and the pair of second openings and coupled to the first ground conductor and the second ground conductor. The middle through-conductor is a ground through-conductor close to the first through-conductor and the second through-conductor in a second direction intersecting with the first direction.

## Description

### TECHNICAL FIELD

The present disclosure relates to a wiring board, an electronic component mounting package using a wiring board, and an electronic module.

### BACKGROUND OF INVENTION

In recent years, in electronic modules used in wireless communication devices and optical communication devices, an increase in a frequency of signals has been demanded to transmit a large amount of information at higher speed. Therefore, wiring boards that transmit signals have been required to transmit radio-frequency signals with small loss.

As wireless communication devices and optical communication devices are reduced in size, wiring boards used for these devices, electronic component mounting packages using the wiring boards, and electronic modules have also been required to be smaller in size.

As the invention described in Patent Literature 1, a known circuit board includes ground via holes arranged around a central conductor that is at a center. The central conductor includes a through-hole at a center thereof and is coupled to a strip line. The ground via hole includes a through-hole at a center thereof (for example, see FIG. 10A of Patent Literature 1).

### CITATION LIST

### PATENT LITERATURE

Patent Literature 1: International Publication No. 2004/107830

### SUMMARY

In an embodiment of the present disclosure, (1) a wiring board includes a first insulating layer, a second insulating layer, a conductor layer, a first ground conductor, and a second ground conductor. The first insulating layer includes a first upper surface and a first side surface connected to the first upper surface. The second insulating layer is positioned on the first insulating layer and includes a second upper surface, a second lower surface on an opposite side to the second upper surface, and a second side surface coupling the second upper surface to the second lower surface. The conductor layer is positioned on the first upper surface and includes a pair of first signal lines and a pair of second signal lines. The pair of first signal lines transmits differential signals and extends in a first direction. The pair of second signal lines transmits differential signals and extends in a first direction. The first ground conductor is positioned on the first upper surface and between the pair of first signal lines and the pair of second signal lines with a gap between the first ground conductor and the pair of first signal lines and a gap between the first ground conductor and the pair of second signal lines. The second ground conductor is positioned on the second upper surface and includes a pair of first openings and a pair of second openings positioned side by side with the pair of first openings. The pair of second signal lines is positioned side by side with the pair of first signal lines. The second insulating layer includes a pair of first through-conductors, a pair of second through-conductors, and one or more middle through-conductors each penetrating from the second upper surface to the second lower surface. Each first through-conductor of the pair of first through-conductors is positioned in a corresponding one of the pair of first openings and electrically coupled to a corresponding one of the pair of first signal lines. Each second through-conductor of the pair of second through-conductors is positioned in a corresponding one of the pair of second openings and electrically coupled to a corresponding one of the pair of second signal lines. The middle through-conductor is positioned between the pair of first openings and the pair of second openings and electrically coupled to the first ground conductor and the second ground conductor, and the middle through-conductor is a ground through-conductor close to one first through-conductor of the pair of first through-conductors as well as a ground through-conductor close to one second through-conductor of the pair of second through-conductors in a second direction intersecting with the first direction.
(2) The wiring board of (1) further includes a third insulating layer positioned on the second upper surface. The third insulating layer includes a third through-conductor and a fourth through-conductor. Each of the third through-conductor and the fourth through-conductor penetrates the third insulating layer and electrically coupled to the second ground conductor. The third through-conductor is positioned between the respective first openings of the pair of first openings. The fourth through-conductor is positioned between the respective second openings of the pair of second openings. In the second direction, the third through-conductor is a ground through-conductor close to each first through-conductor of the pair of first through-conductors, and the fourth through-conductor is a ground through-conductor close to each second through-conductor of the pair of second through-conductors.
(3) In the wiring board of (1) or (2), each opening of the pair of first openings and the pair of second openings has a circular shape in plan view.
(4) In the wiring board of (2) or (3), the third through-conductor, the fourth through-conductor, and the middle through-conductor are positioned in a straight line in the second direction.
(5) In the wiring board of (2) to (4), the pair of first through-conductors, the pair of second through-conductors, the third through-conductor, the fourth through-conductor, and the middle through-conductor are positioned in a straight line in the second direction.
(6) In the wiring board of (2) to (5), when a distance in the second direction between the third through-conductor and the middle through-conductor is L3, and a distance in the second direction between the fourth through-conductor and the middle through-conductor is L4, L3 = L4 is satisfied.
(7) In the wiring board of (1) to (6), in plan view, the second ground conductor includes a pair of third openings and a pair of fourth openings. Each third opening of the pair of third openings overlaps a corresponding one of the pair of first signal lines, and each fourth opening of the pair of fourth openings overlaps a corresponding one of the pair of second signal lines.
(8) In the wiring board of (7), in the second direction, when a dimension of each first opening of the pair of first openings is OL1, a dimension of each second opening of the pair of second openings is OL2, a dimension of each third opening of the pair of third openings is OL3, and a dimension of each fourth opening of the pair of fourth openings is OL4, OL1 ≥ OL3, and OL2 ≥ OL4 are satisfied.
(9) In the wiring board of (1) to (8), the first insulating layer includes a projecting part extending outward in the first direction from the second side surface of the second insulating layer in plan view and including the first side surface. The projecting part includes a first surface of the first upper surface of the first insulating layer, and a first opening part and a second opening part that open at the first surface. The first surface extends from the second side surface of the second insulating layer in the first direction. The pair of first signal lines and the pair of second signal lines extend on the first surface of the projecting part. The first opening part is positioned between the respective first signal lines of the pair of first signal lines. The second opening part is positioned between the respective second signal lines of the pair of second signal lines.
(10) In the wiring board of (9), in plan view, the respective first signal lines of the pair of first signal lines include first connection parts and first line parts extending inward in the first direction from the corresponding first connection parts. The respective second signal lines of the pair of second signal lines include second connection parts and second line parts extending inward in the first direction from the corresponding second connection parts. The first opening part is positioned between the first line parts constituting a pair. The second opening part is positioned between the second line parts constituting a pair. In the second direction, a dimension of each first line part of the first line parts is shorter than a dimension of each first connection part of the first connection parts, and a dimension of each second line part of the second line parts is shorter than a dimension of each second connection part of the second connection parts.
(11) In the wiring board of (9) or (10), the projecting part includes a first middle cutout part cutout from the first surface to the first side surface. The first middle cutout part includes a first inner wall surface connected to the first surface and the first side surface. The first middle cutout part overlaps the middle through-conductor in side view in the first direction. The first ground conductor extends from on the first surface to on the first inner wall surface.
(12) In the wiring board of (1) to (11), the second insulating layer includes a second middle cutout part cutout from the second upper surface to the second side surface. The second middle cutout part includes a second inner wall surface connected to the second upper surface and the second side surface. The second middle cutout part overlaps the middle through-conductor in side view in the first direction. The second ground conductor extends from the second upper surface to on the second inner wall surface.
(13) The wiring board of (2) to (12) further includes a third ground conductor. The third insulating layer may include a third upper surface, a third side surface, a third lower surface, an inner side-surface, and an inner cutout part. The third lower surface is positioned on an opposite side to the third upper surface. The third side surface couples the third upper surface to the third lower surface and is positioned on a same plane as the second side surface. The inner side-surface couples the third upper surface to the third lower surface and includes a fourth side surface on an opposite side to the third side surface. The inner side-surface includes a lateral side-surface in the first direction, and a corner part between the lateral side-surface and the fourth side surface. The corner part has an arc shape in plan view. The inner cutout part is cutout from the third upper surface to the fourth side surface. The inner cutout part includes a third inner wall surface continuing to the corner part and the fourth side surface. The third ground conductor is positioned on the third upper surface and extends from the third upper surface to on the third inner wall surface.
(14) According to an embodiment of the present disclosure, an electronic component mounting package includes the wiring board of (1) to (13), a base body, and a frame body. The frame body is bonded to an upper surface of a substrate, and the wiring board is secured to the frame body. The wiring board may be bonded to the upper surface of the substrate.
(15) According to an embodiment of the present disclosure, an electronic module includes the electronic component mounting package of (14), an electronic component, and a lid body. The electronic component is positioned on the upper surface of the substrate and electrically coupled to the wiring board of the electronic component mounting package. The lid body is positioned on the frame body to cover an internal portion of the electronic component mounting package.

### BRIEF DESCRIPTION OF THE DRAWINGS

FIG. 1 is a perspective view of a wiring board, an electronic component mounting package, and an electronic module according to an embodiment of the present disclosure.
FIG. 2 is an enlarged view in which a part A of interest illustrated in FIG. 1 is seen from another angle.
FIG. 3 is a perspective view in which the part A of interest illustrated in FIG. 2 is cut along line X1-X1.
FIG. 4 is a plan view of the part A of interest illustrated in FIG. 3.
FIG. 5 is an enlarged view of a part B of interest illustrated in FIG. 4.
FIG. 6 is a planar transparent view of the part A of interest illustrated in FIG. 3.
FIG. 7 is a sectional view of the part A of interest illustrated in FIG. 6 when taken along line Y1-Y1.
FIG. 8 is a plan view of a wiring board, an electronic component mounting package, and an electronic module according to an embodiment of the present disclosure.
FIG. 9 is an enlarged view of a part C of interest illustrated in FIG. 8.

### DESCRIPTION OF EMBODIMENTS

### <Configuration of Wiring Board>

Hereinafter, several exemplary embodiments of the present disclosure are described with reference to the drawings. Note that any direction may be defined as an upper direction or a lower direction regarding a wiring board. However, for convenience, an orthogonal coordinate system xyz is defined, and a positive side in a z-direction is assumed as the upper direction. Below, a first direction indicates, for example, an x-direction in the drawings. A second direction intersecting with the first direction indicates, for example, a y-direction in the drawings. In the present disclosure, plan view is a concept including planar transparent view.

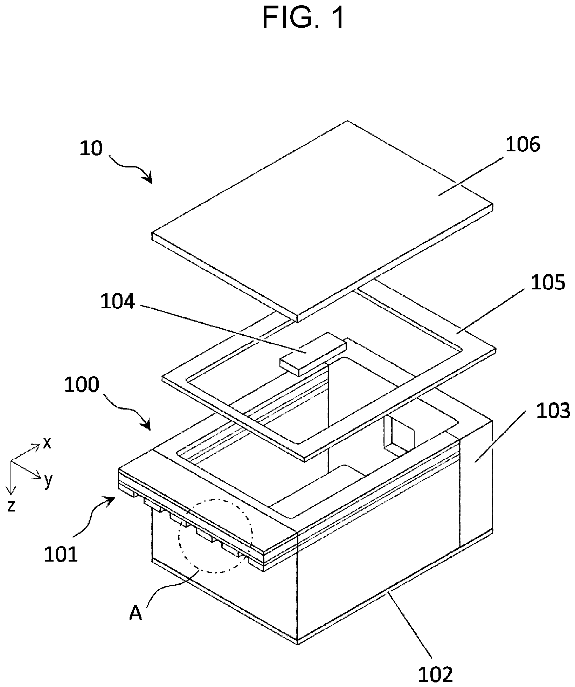

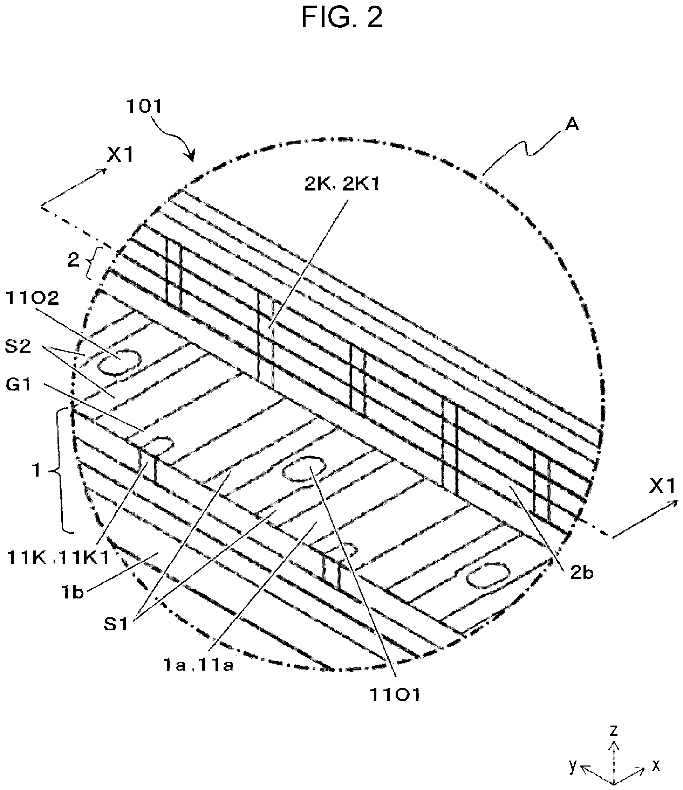

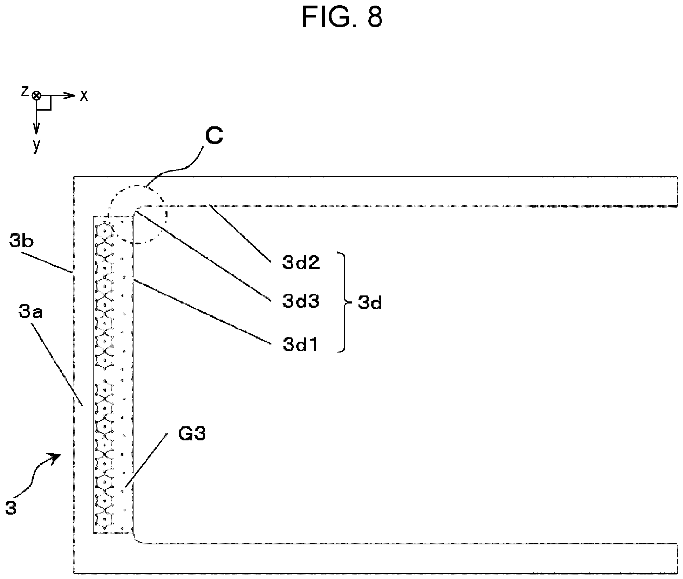

In an embodiment of the present disclosure, a wiring board 101 is described with reference to FIGs. 1 to 9. The wiring board 101 at least includes a first insulating layer 1, a second insulating layer 2, a conductor layer S, a first ground conductor layer G1, and a second ground conductor G2. The wiring board 101 may further include a third insulating layer 3. For example, a wire, a flexible substrate (FPC: flexible printed circuit), and/or a lead terminal may be coupled to the wiring board 101. Note that FIG. 2 is an enlarged view of a part A of interest when the wiring board 101, an electronic component mounting package 100, and an electronic module 10, that are illustrated in FIG. 1, are seen from the positive direction of the z-axis.

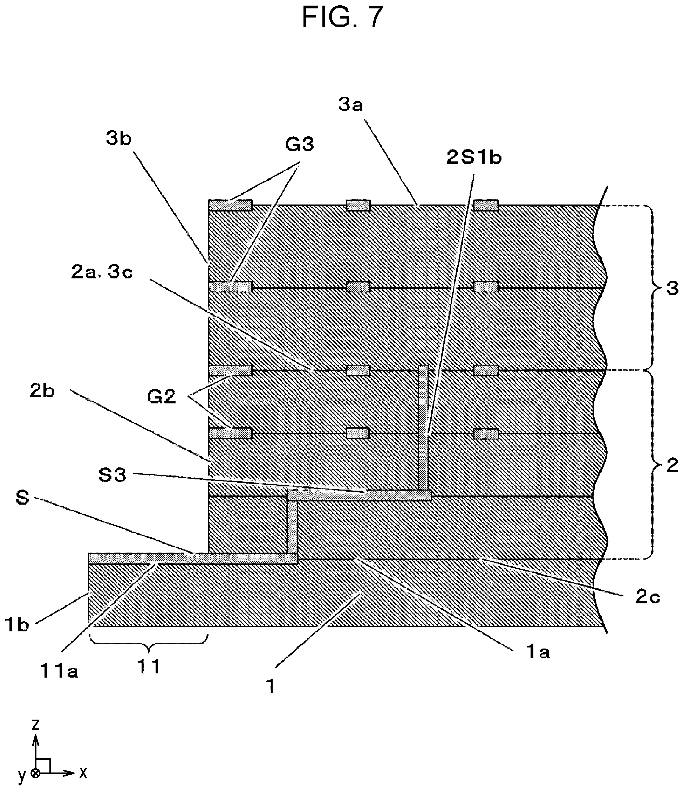

As illustrated in FIG. 7, the first insulating layer 1 includes a first upper surface 1a and a first side surface 1b connected to the first upper surface 1a. As a material for the first insulating layer 1, for example, a dielectric material, such as a ceramic material, for example, an aluminum oxide-based sintered body, a mullite-based sintered body, a silicon carbide-based sintered body, an aluminum nitride-based sintered body, or a silicon nitride-based sintered body, or a glass-ceramic material can be used.

The first insulating layer 1 may include a configuration in which multiple insulating layers are laminated on one another. For example, the first insulating layer 1 has a U-shape in plan view, a size of 4 mm × 4 mm to 50 mm × 50 mm, and a thickness of 0.5 mm to 10 mm.

As illustrated in FIG. 7, the second insulating layer 2 is positioned on the first insulating layer 1 and includes a second upper surface 2a, a second lower surface 2c on the opposite side to the second upper surface 2a, and a second side surface 2b coupling the second upper surface 2a to the second lower surface 2c. The second lower surface 2c can be defined as a surface facing the first upper surface 1a. A material for the second insulating layer 2 may be the same as or different from the material for the first insulating layer 1, and for example, a material the same as and/or similar to the material for the first insulating layer 1 described above can be used. The second insulating layer 2 may include a configuration in which multiple insulating layers are laminated on one another. For example, the second insulating layer 2 has a U-shape in plan view, a size of 4 mm × 4 mm to 50 mm × 50 mm, and a thickness of 0.5 mm to 10 mm.

As illustrated in FIGs. 2 to 7, the conductor layer S is positioned on the first upper surface 1a and includes a pair of first signal lines S1 and a pair of second signal lines S2. Each signal line of the pair of first signal lines S1 and the pair of second signal lines S2 transmits a differential signal and extends in the first direction (in an embodiment, the x-direction). Examples of a material for the conductor layer S (the pair of first signal lines S1, the pair of second signal lines S2) include a metal material, such as gold, silver, copper, nickel, tungsten, molybdenum, or manganese. The conductor layer S may be formed by sintering of metal paste on the first upper surface 1a, or formed by using a thin-film formation technology, such as a vapor deposition method or a sputtering method. An insulating film, such as a ceramic (for example, alumina coating) or a resin may be positioned on a portion of the conductor layer S. The insulating film can be provided onto each of the signal lines (the pair of first signal lines S1 and the pair of second signal lines S2) by screen printing. The insulating film may be positioned only on a portion of each signal line. Such a configuration can lower possibility of short-circuiting in each signal line.

The pair of second signal lines S2 is positioned side by side with the pair of first signal lines S1. Metal plating, such as nickel plating or gold plating may be formed on a surface of the pair of first signal lines S1 and the pair of second signal lines S2. For example, each signal line of the pair of first signal lines S1 and the pair of second signal lines S2 has a width of 0.05 mm to 2 mm, and a length of 1.5 mm to 25 mm.

For example, each signal line of the pair of first signal lines S1 and the pair of second signal lines S2 has a thickness of 0.01 to 0.1 mm. Note that the width, the length, and the thickness of each signal line of the pair of first signal lines S1 and the pair of second signal lines S2 as used herein can respectively indicate a y-direction dimension, an x-direction dimension, and a z-direction dimension of each signal line of the pair of first signal lines S1 and the pair of second signal lines S2. A width/length/thickness of each ground conductor of the first ground conductor G1 and the second ground conductor G2 described later can also be defined in the same and/or similar manner. Note that the width/length/thickness of each signal line of the pair of first signal lines S1 may respectively be the same as or similar to the width/length/thickness of the pair of first signal lines S1.

As illustrated in FIGs. 2 to 7, the first ground conductor G1 is positioned on the first upper surface 1a. The first ground conductor G1 is positioned between the pair of first signal lines S1 and the pair of second signal lines S2 with a gap between the first ground conductor G1 and the pair of first signal lines S1 and a gap between the first ground conductor G1 and the pair of second signal lines S2. In an embodiment, the first ground conductor G1 may extend in the first direction (x-direction). A material for the first ground conductor G1 may be the same as or different from the material for the conductor layer S, and be, for example, a material the same as and/or similar to the material for the conductor layer S described above. The first ground conductor G1 may be formed in a method the same as and/or similar to that for the conductor layer S described above. For example, the first ground conductor G1 has a width of 0.05 mm to 2 mm, and a length of 1.5 mm to 25 mm. For example, the first ground conductor G1 has a thickness of 0.01 mm to 0.1 mm.

Positioning of the first ground conductor G1 between the pair of first signal lines S1 and the pair of second signal lines S2 can reinforce ground potential and strengthen electric coupling. Therefore, the conductor layer S can have less possibility of occurrence of crosstalk and/or resonance. The crosstalk and/or resonance occurs due to spreading of electric field distribution beyond a desired range during transmission of a radio-frequency signal.

The second ground conductor G2 is positioned on the second upper surface 2a. The second ground conductor G2 includes a pair of first openings O1 (a first opening O1a, a first opening O1b) and a pair of second openings O2 (a second opening O2a, a second opening O2b) positioned side by side with the pair of first openings O1. The pair of first openings O1 and the pair of second openings O2 are a region at which the second ground conductor G2 is not formed in plan view. In an embodiment, the first ground conductor G1 may extend in the first direction (x-direction). A material for the second ground conductor G2 may be the same as or different from the material for the conductor layer S, and may be, for example, a material the same as and/or similar to the material for the conductor layer S described above. The second ground conductor G2 may be formed in a method the same as and/or similar to that for the conductor layer S described above. For example, the second ground conductor G2 has a thickness of 0.01 mm to 0.1 mm.

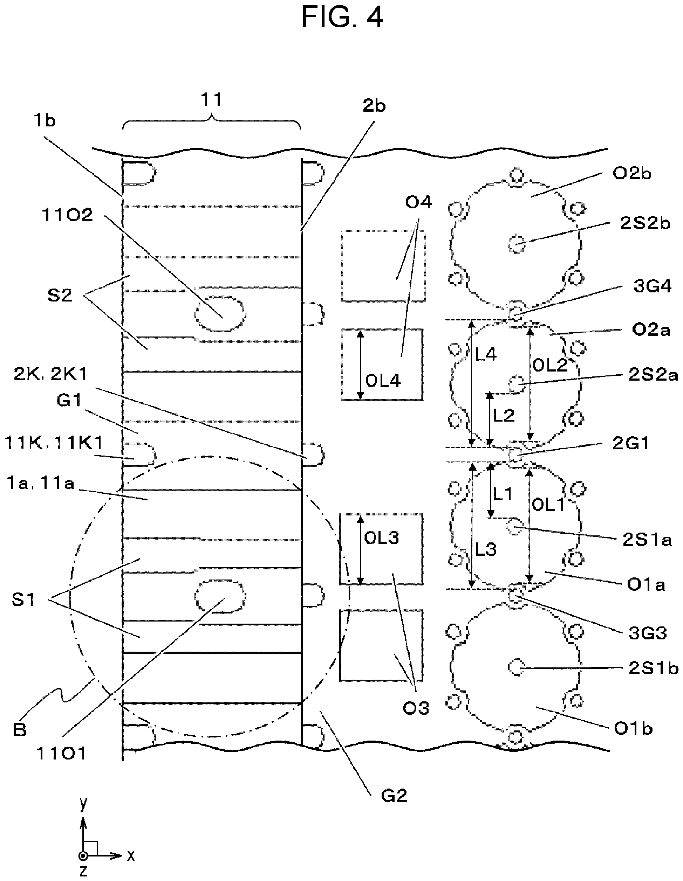

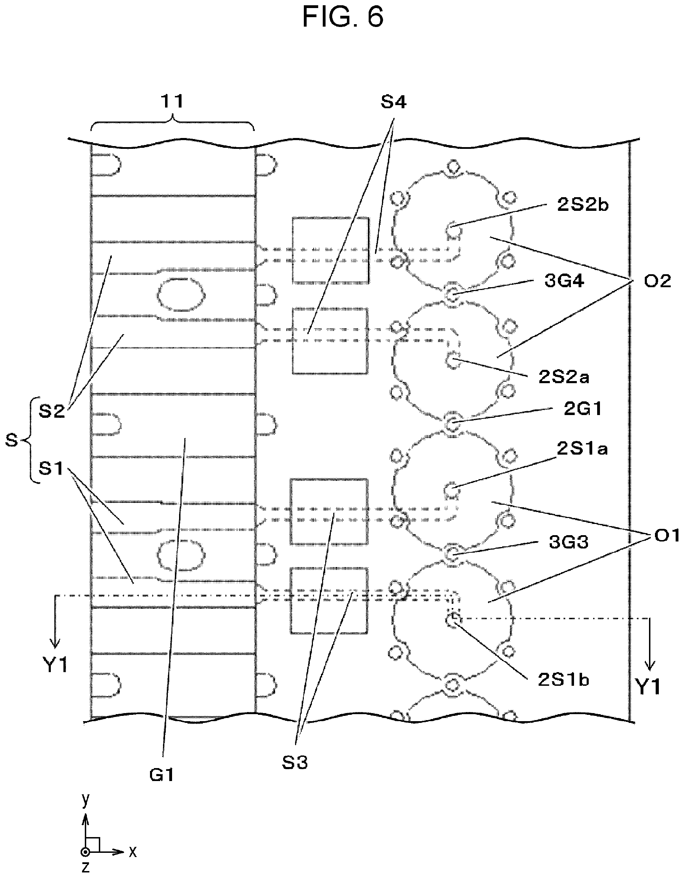

As illustrated in FIGs. 4 and 6, each opening of the pair of first openings O1 and the pair of second openings O2 may have a circular shape in plan view. The circular shape as used herein is not limited to a perfect circle, but may be an ellipse-like shape or a circle with partial cutout. In an embodiment, as illustrated in FIGs. 4 and 6, each opening of the pair of first openings O1 and the pair of second openings O2 may be a circle with partial cutout at a portion adjacent to a middle through-conductor 2G1 described later. More specifically, in plan view, each opening of the first opening O1a and the second opening O2a includes a portion along the middle through-conductor 2G1 and in a shape along an outer periphery of the middle through-conductor 2G1. Thereby, the second ground conductor G2 can be positioned between the middle through-conductor 2G1 and the first opening O1a and between the middle through-conductor 2G1 and the second opening O2a, thus reinforcing ground potential.

In the case in which the second insulating layer 2 includes the configuration in which multiple insulating layers are laminated on one another, the wiring board 101 includes multiple second ground conductors G2, and each second ground conductor G2 may be positioned between the respective insulating layers that constitute the second insulating layer 2. In this case, all of the second ground conductors G2 do not need to have the same shape in plan view. For example, in the second ground conductor G2 positioned between the respective insulating layers that constitute the second insulating layer 2, the pair of first openings O1 may be a single coupled opening in plan view, and the pair of second openings O2 may be a single coupled opening in plan view.

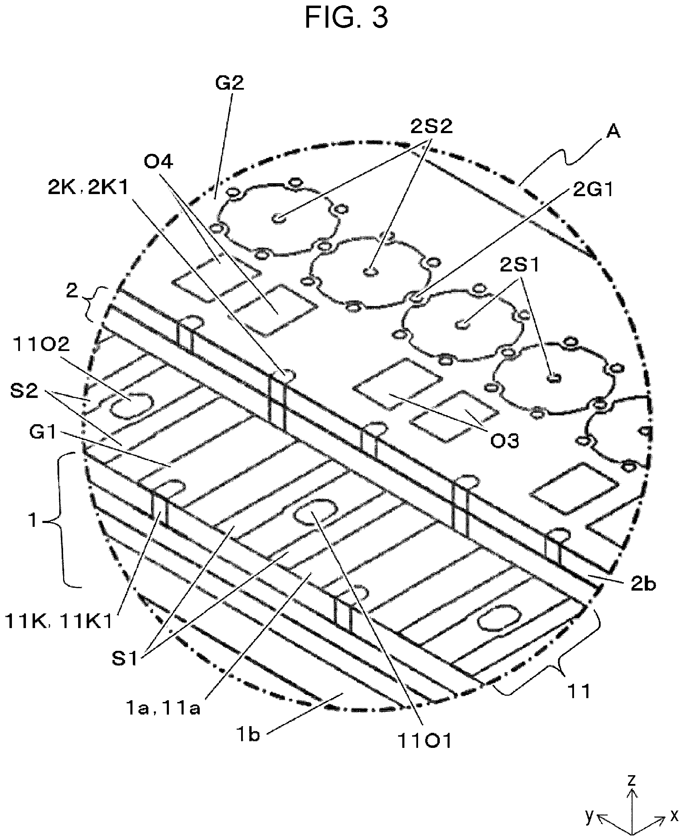

As illustrated in FIGs. 3, 4, 6, and 7, the second insulating layer 2 includes a pair of first through-conductors 2S1, a pair of second through-conductors 2S2, and one or more middle through-conductors 2G1. Each through-conductor of the first through-conductor 2S1, the second through-conductor 2S2, and the middle through-conductor 2G1 penetrates from the second upper surface 2a to the second lower surface 2c. The pair of first through-conductors 2S1 can be formed by through-holes provided to the second insulating layer 2 being filled with metal paste including a metal material, such as gold, silver, copper, nickel, tungsten, molybdenum, or manganese. The pair of second through-conductors 2S2 and the middle through-conductor 2G1 can also be formed in a method the same as and/or similar to that for the pair of first through-conductors 2S1.

The pair of first through-conductors 2S1, the pair of second through-conductors 2S2, and the middle through-conductor 2G1 may be vias formed by through-holes being filled with metal paste. Alternatively, the pair of first through-conductors 2S1, the pair of second through-conductors 2S2, and the middle through-conductor 2G1 may be through-holes formed by metal paste being applied to inner wall surfaces of the through-holes. In an embodiment, the pair of first through-conductors 2S1, the pair of second through-conductors 2S2, and the middle through-conductor 2G1 are vias formed in the method described above. In this case, as compared with a case in which the pair of first through-conductors 2S1, the pair of second through-conductors 2S2, and the middle through-conductor 2G1 are through-holes, the wiring board 101 can have less possibility of reduction in its strength when the wiring board 101 has a reduced size. That is, in the case in which the wiring board 101 has a reduced size, the pair of first through-conductors 2S1, the pair of second through-conductors 2S2, and the middle through-conductor 2G1 are provided close to one another. However, since the pair of first through-conductors 2S1, the pair of second through-conductors 2S2, and the middle through-conductor 2G1 are vias formed by through-holes being filled with metal paste, the wiring board 101 can have less possibility of reduction in its strength as compared with the case of these conductors being through-holes.

As illustrated in FIGs. 4 and 6, each first through-conductor of the pair of first through-conductors 2S1 is positioned in the corresponding one of the pair of first openings O1 and electrically coupled to the corresponding one of the pair of first signal lines S1. Each second through-conductor of the pair of second through-conductors 2S2 is positioned in the corresponding one of the pair of second openings O2 and electrically coupled to the corresponding one of the pair of second signal lines. In plan view, each first through-conductor of the pair of first through-conductors 2S1 (a first through-conductor 2S1a and a first through-conductor 2S1b) is positioned in the corresponding one of the pair of first openings O1 (the first opening O1a, the first opening O1b). In plan view, each second through-conductor of the pair of second through-conductors 2S2 (a second through-conductor 2S2a and a second through-conductor 2S2b) is positioned in the corresponding one of the pair of second openings O2 (the second opening O2a, the second opening O2b). The configuration as described above can provide a pseudo coaxial structure and less possibility of an increase in loss of transmitted signals while transmitting signals in a direction in which the first insulating layer 1 and the second insulating layer 2 are laminated on one another (in an embodiment, the z-direction).

In an embodiment, specifically, in plan view, the first through-conductor 2S1a is positioned at a center of the first opening O1a, and the first through-conductor 2S1b is positioned at a center of the first opening O1b. In plan view, the second through-conductor 2S2a is positioned at a center of the second opening O2a, and the second through-conductor 2S2b is positioned at a center of the second opening O2b. With such a configuration, each through-conductor of the pair of first through-conductors 2S1 and the pair of second through-conductors 2S2 forms a differential pseudo coaxial structure to transmit a differential signal. Such a configuration allows current in opposite phases to flow in the respective ones of the first through-conductor 2S1a and the first through-conductor 2S1b to cancel out external noise, thus reducing influence of EMI noise. Therefore, transmission of radio-frequency signals can be smoother. In the same and/or similar manner, also in the second through-conductor 2S2a and the second through-conductor 2S2b, transmission of radio-frequency signals can be smooth. Each through-conductor of the pair of first through-conductors 2S1 is not necessarily directly joined to the corresponding one of the pair of first signal lines S1 as long as each one of the pair of first through-conductors 2S1 is electrically coupled to the corresponding one of the pair of first signal lines S1.

In an embodiment, the wiring board 101 may include a first interlayer signal conductor S3 and a second interlayer signal conductor S4. In FIG. 6, the first interlayer signal conductor S3 and the second interlayer signal conductor S4 described later are indicated by dotted lines. Each first through-conductor of the pair of first through-conductors 2S1 is coupled to the corresponding one of the pair of first signal lines S1 via the first interlayer signal conductor S3. Each second through-conductor of the pair of second through-conductors 2S2 is coupled to the corresponding one of the pair of second signal lines S2 via the second interlayer signal conductor S4. Note that a material for the first interlayer signal conductor S3 and the second interlayer signal conductor S4 may be the same as or different from the material for the conductor layer S, and may be, for example, a material the same as and/or similar to the material for the conductor layer S described above. The first interlayer signal conductor S3 and the second interlayer signal conductor S4 may be formed in a method the same as and/or similar to that for the conductor layer S described above. For example, each of the first interlayer signal conductor S3 and the second interlayer signal conductor S4 has a width of 0.05 mm to 2 mm, and a length of 1.5 mm to 25 mm. For example, each of the first interlayer signal conductor S3 and the second interlayer signal conductor S4 has a thickness of 0.01 mm to 0.1 mm.

As illustrated in FIGs. 3 to 6, the middle through-conductor 2G1 is positioned between the pair of first openings O1 and the pair of second openings O2. The middle through-conductor 2G1 is electrically coupled to the first ground conductor G1 and the second ground conductor G2. The middle through-conductor 2G1 is a ground through-conductor close to the first through-conductor 2S1a as well as a ground through-conductor close to the second through-conductor 2S2a in the second direction (in an embodiment, the y-direction) intersecting with the first direction.

With the configuration as described above, the wiring board 101 can have a reduced size with less possibility of occurrence of crosstalk.

In an embodiment, assuming that a distance between the middle through-conductor 2G1 and the first through-conductor 2S1 close thereto is L1, and a distance between the middle through-conductor 2G1 and the second through-conductor 2S2 close thereto is L2, L1 = L2 is satisfied. With such a configuration, the wiring board 101 can have a reduced size while maintaining preferable radio frequency transmission.

Here, as illustrated in FIG. 4, in an embodiment, the number of middle through-conductor 2G1 may be one. With such a configuration, the wiring board 101 may further be reduced in size with less occurrence of crosstalk. Note that the number of middle through-conductor 2G1 may be more than one, and the number of middle through-conductor 2G1 is appropriately adjustable in accordance with a frequency of transmitted signals. That is, for example, two middle through-conductors 2G1 aligned in the first direction may be positioned between the pair of first openings O1 and the pair of second openings O2.

As illustrated in FIGs. 2 and 7, the wiring board 101 may include the third insulating layer 3 positioned on the second upper surface 2a. The third insulating layer 3 includes a third through-conductor 3G3 and a fourth through-conductor 3G4. Each of the third through-conductor 3G3 and the fourth through-conductor 3G4 penetrates the third insulating layer 3 and is electrically coupled to the second ground conductor G2. A material for the third insulating layer 3 may be the same as or different from the material for the first insulating layer 1, and for example, a material the same as and/or similar to the material for the first insulating layer 1 described above can be used. The third insulating layer 3 may include a configuration in which multiple insulating layers are laminated on one another. For example, the third insulating layer 3 has a U-shape in plan view, a size of 4 mm × 4 mm to 50 mm × 50 mm, and a thickness of 0.5 mm to 10 mm.

The wiring board 101 may include a third ground conductor G3 positioned on the third insulating layer 3. The third ground conductor G3 is made of a material and formed in a method the same as and/or similar to those for the conductor layer S described above. As illustrated in FIG. 7, in the case in which the third insulating layer 3 includes the configuration in which multiple insulating layers are laminated on one another, the third ground conductor G3 may be positioned between the insulating layers that constitute the third insulating layer 3. In this case, the third ground conductor G3 may electrically be coupled to the third through-conductor 3G3 and the fourth through-conductor 3G4.

As illustrated in FIG. 4, the third through-conductor 3G3 is positioned between the respective first openings of the pair of first openings O1. The fourth through-conductor 3G4 is positioned between the respective second openings of the pair of second openings O2. In the second direction (y-direction), the third through-conductor 3G3 is a ground through-conductor close to each first through-conductor of the pair of first through-conductors 2S1, and the fourth through-conductor 3G4 is a ground through-conductor close to each second through-conductor of the pair of second through-conductors 2S2. More specifically, in the second direction (y-direction), a distance from the third through-conductor 3G3 to the first through-conductor 2S1a is the same as a distance from the third through-conductor 3G3 to the first through-conductor 2S1b. The third through-conductor 3G3 and the fourth through-conductor 3G4 can be formed by through-holes provided to the third insulating layer 3 being filled with metal paste including a metal material, such as gold, silver, copper, nickel, tungsten, molybdenum, or manganese.

In an embodiment, the third through-conductor 3G3 may be positioned with a gap between the third through-conductor 3G3 and the first opening O1a and a gap between the third through-conductor 3G3 and the first opening O1b. The fourth through-conductor 3G4 is positioned with a gap between the fourth through-conductor 3G4 and the second opening O2a and a gap between the fourth through-conductor 3G4 and the second opening O2b. The second ground conductor G2 is positioned between the third through-conductor 3G3 and each first opening of the pair of first openings O1, and between the fourth through-conductor 3G4 and each second opening of the pair of second openings O2. As described above, in the case in which the wiring board 101 includes the third ground conductor G3, and the third ground conductor G3 is electrically coupled to the third through-conductor 3G3 and the fourth through-conductor 3G4, electrical coupling between the multi-layered ground conductors (in an embodiment, the second ground conductor G2 and the third ground conductor G3) via the third through-conductor 3G3 and the fourth through-conductor 3G4 can reinforce ground potential.

The third through-conductor 3G3, the fourth through-conductor 3G4, and the middle through-conductor 2G1 may be positioned in a straight line in the second direction (in an embodiment, the y-direction). This arrangement can reinforce ground potential while disposing the respective first openings of the pair of first openings O1 with a shortest distance therebetween, and can reinforce ground potential while disposing the respective second openings of the pair of second openings O2 with a shortest distance therebetween. Ground potential can be reinforced also while the pair of first openings O1 and the pair of second openings O2 are disposed with a shortest distance therebetween. Therefore, the wiring board 101 can have a reduced size with reinforced ground potential.

The pair of first through-conductors 2S1, the pair of second through-conductors 2S2, the third through-conductor 3G3, the fourth through-conductor 3G4, and the middle through-conductor 2G1 may be positioned in a straight line in the second direction. This arrangement enables the wiring board 101 to have a reduced size with reinforced ground potential as a result of an effect the same as and/or similar to that described above.

As illustrated in FIG. 4, in plan view, assuming that a distance in the second direction between the third through-conductor 3G3 and the middle through-conductor 2G1 is L3, and a distance in the second direction between the fourth through-conductor 3G4 and the middle through-conductor 2G1 is L4, L3 = L4 may be satisfied. In this case, impedance adjustment of the first signal line S1 and the second signal line S2 becomes easier, and thus the wiring board 101 can have improved radio-frequency characteristics.

As illustrated in FIG. 4, the second ground conductor G2 may include a pair of third openings O3 and a pair of fourth openings O4. Each third opening of the pair of third openings O3 overlaps the corresponding one of the pair of first signal lines S1 in plan view. Each fourth opening of the pair of fourth openings O4 overlaps the corresponding one of the pair of second signal lines S2 in plan view. Such a configuration can provide less possibility of a reduction in an impedance value at the pair of first signal lines S1 and the pair of second signal lines S2 each signal line of which transmits a differential signal, and impedance adjustment to a desired value. Such a wiring board 101 excels in transmission characteristics of radio-frequency signals.

The following description takes the pair of third openings O3 for an example. However, the pair of fourth openings O4 may also have a configuration the same as and/or similar to that for the pair of third openings O3 or may have a configuration different therefrom.

In plan view, as long as each third opening the pair of third openings O3 overlaps at least a portion of the corresponding one of the pair of first signal lines S1, each third opening of the pair of third openings O3 does not need to overlap the whole of the corresponding one of the pair of first signal lines S1. In plan view, each third opening of the pair of third openings O3 may have a substantially rectangular shape or may have a circular shape including an ellipse-like shape. Here, the substantially rectangular shape may include a shape in which a part of the rectangular shape is along a contour of a via connected to the second ground conductor G2 in plan view.

In the case in which the wiring board 101 includes the first interlayer signal conductor S3 and the second interlayer signal conductor S4 described above, in plan view, the pair of third openings O3 may overlap the first interlayer signal conductor S3, and the pair of fourth openings O4 may overlap the second interlayer signal conductor S4. In an embodiment, each third opening of the pair of third openings O3 may overlap the corresponding one of the pair of first signal lines S1 and the first interlayer signal conductor S3, and each fourth opening of the pair of fourth openings O4 may overlap the corresponding one of the pair of second signal lines S2 and the second interlayer signal conductor S4.

More specifically, in an embodiment, one first signal line S1 and one first interlayer signal conductor S3 may be positioned at a portion of one third opening O3. The portion is closer the other third opening O3 from a middle point of the one third opening O3 in the second direction. In this case, differential signals can have improved coupling.

As illustrated in FIG. 4, in the second direction (y-direction), assuming that a dimension of each first opening of the pair of first openings O1 is OL1, a dimension of each second opening of the pair of second openings O2 is OL2, a dimension of each third opening of the pair of third openings O3 is OL3, and a dimension of each fourth opening of the pair of fourth openings O4 is OL4, OL1 ≥ OL3, and OL2 ≥ OL4 may be satisfied. Reduction in an area of the second ground conductor G2 positioned on the second upper surface 2a due to an excessive increase in the dimension OL3 of each third opening of the pair of third openings O3, and thus weakening of ground potential are reducible. That is, the dimension OL3 of each third opening of the pair of third openings O3 being equal to or less than the dimension OL1 of each first opening of the pair of first openings O1 can avoid a situation in which ground potential is unstable. In the same and/or similar manner, the dimension OL4 of each fourth opening of the pair of fourth openings O4 being equal to or less than the dimension OL2 of each second opening of the pair of second openings O2 can avoid a situation in which ground potential is unstable.

As illustrated in FIGs. 2 to 7, the first insulating layer 1 may include a projecting part 11. The projecting part 11 is a portion of the first insulating layer 1 extending in the first direction (x-direction) outward (in an embodiment, the negative direction of the x-axis) from the second side surface 2b of the second insulating layer 2 in plan view, and including the first side surface 1b. The projecting part 11 includes a first surface 11a of the first upper surface 1a of the first insulating layer 1, and a first opening part 11O1 and a second opening part 1102 that open at the first surface 11a. In plan view, the first surface 11a extends from the second side surface 2b of the second insulating layer 2 in the first direction. The pair of first signal lines S1 and the pair of second signal lines S2 extend on the first surface 11a of the projecting part 11. The first opening part 11O1 is positioned between the respective first signal lines of the pair of first signal lines S1, and the second opening part 1102 is positioned between the respective second signal lines of the pair of second signal lines S2. With such a configuration, the first insulating layer 1 positioned between the respective ones of the pair of first signal lines S1 and between the respective ones of the pair of second signal lines S2 can have a reduced dielectric constant, and the pair of first signal lines S1 and the pair of second signal lines S2 can have less reduction in impedance. Therefore, using of the wiring board 101 can provide the electronic component mounting package 100 and the electronic module 10 capable of reducing loss in transmission of a radio-frequency signal.

In an embodiment, each of the first opening part 11O1 and the second opening part 1102 may be a recess part positioned at the projecting part 11, and may have a substantially ellipse-like shape in plan view. Such a shape can reduce stress that occurs at a corner part and lower possibility of the wiring board 101 getting damaged as compared with the case in which each of the first opening part 11O1 and the second opening part 1102 has a rectangular shape.

Note that each of the first opening part 11O1 and the second opening part 1102 may have an ellipse-like shape, a square-like shape, or a rectangular shape with rounded corner parts in plan view. The first opening part 11O1 and the second opening part 1102 may extend to the first side surface 1b. That is, each of the first opening part 11O1 and the second opening part 1102 may have a shape cutout from the first surface 11a to the first side surface 1b. The first opening part 11O1 and the second opening part 1102 may extend to a position overlapping the second side surface 2b in plan view.

In an embodiment, as illustrated in FIG. 4, the first opening part 11O1 and the second opening part 1102 may be positioned in a symmetrical manner while sandwiching the first ground conductor G1 therebetween and may have the same shape as one another. With such a configuration, the first opening part 11O1 and the second opening part 1102 can be formed by punching processing to form the same shape, and therefore manufacturing of the wiring board 101 becomes easier. Moreover, adjustment and matching of impedance of signals transmitted through the pair of first signal lines S1 and the pair of second signal lines S2 can be easier.

Note that the shape, the position, and the size of the first opening part 11O1 and the second opening part 1102 are not limited to those described above. That is, the first opening part 11O1 and the second opening part 1102 may have different sizes from one another, and the first opening part 11O1 and the second opening part 1102 may be provided to appropriate positions where reduction in a decrease in impedance is necessary.

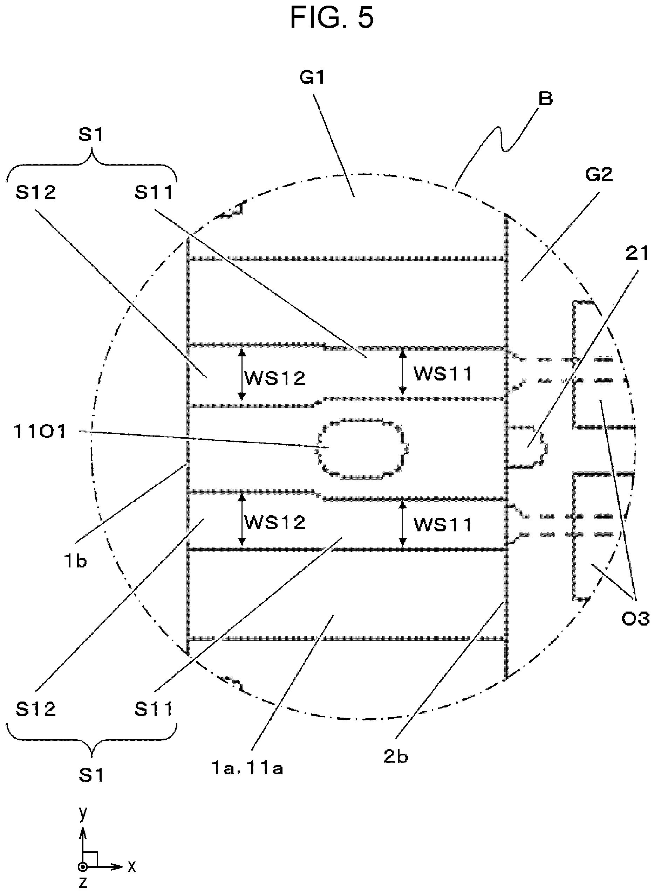

As illustrated in FIG. 5, in plan view, the respective first signal lines of the pair of first signal lines S1 include first connection parts S12 and first line parts S11 extending inward in the first direction from the corresponding first connection parts S12. The respective second signal lines of the pair of second signal lines S2 may include second connection parts S22 and second line parts S21 extending inward (in the positive direction of the x-axis) in the first direction (x-direction) from the corresponding second connection parts S22. In this case, the first opening part 1101 is positioned between the first line parts S11 constituting a pair, and the second opening part 1102 is positioned between the second line parts S21 constituting a pair. In the second direction (y-direction), a dimension WS11 of each first line part of the first line parts S11 is shorter than a dimension WS12 of each first connection part of the first connection parts S12, and a dimension WS21 of each second line part of the second line parts S21 is shorter than a dimension WS22 of each second connection part of the second connection parts S22. That is, WS11 < WS12, and WS21 < WS22 are satisfied.

With the configuration as described above, securing of a region for coupling a wire, a lead terminal, and/or a flexible substrate to each connection part (the first connection part S12, the second connection part S22) of the corresponding signal line and coupling the wire and the like to each connection part can be easier. When a lead terminal is coupled to each connection part (the first connection part S12, the second connection part S22), the lead terminal is coupled through a conductive bonding material (for example, solder or a silver brazing material). Therefore, the bonding material can easily form a fillet from each connection part to the lead terminal, and thus bonding strength between the lead terminal and the wiring board 101 can improve.

Note that in an embodiment the pair of second signal lines S2 (the second line part S21, the second connection part S22) has a shape and a dimension the same as and/or similar to those of the pair of first signal lines S1 (the first line part S11, the first connection part S12). Therefore, in FIG. 5, illustration of the pair of second signal lines S2 (the second line part S21, the second connection part S22), the dimension WS21 of the second line part S21, and the dimension WS22 of the second connection part S22 is omitted.

As illustrated in FIGs. 2 to 4, the projecting part 11 may include a first middle cutout part 11K cutout from the first surface 11a to the first side surface 1b. The first middle cutout part 11K includes a first inner wall surface 11K1 connected to the first surface 11a and the first side surface 1b. When seen in side view in the first direction (x-direction), the first middle cutout part 11K overlaps the middle through-conductor 2G1. The first ground conductor G1 may extend from on the first surface 1a to on the first inner wall surface 11K1. Such a configuration can reinforce ground potential and lower possibility of loss of signals transmitted through each signal line.

As illustrated in FIGs. 2 to 4, the second insulating layer 2 may include a second middle cutout part 2K cutout from the second upper surface 2a to the second side surface 2b. In this case, the second middle cutout part 2K includes a second inner wall surface 2K1 connected to the second upper surface 2a and the second side surface 2b. When seen in side view in the first direction (x-direction), the second middle cutout part 2K overlaps the middle through-conductor 2G1. The second ground conductor G2 may extend from the second upper surface 2a to on the second inner wall surface 2K1. Such a configuration can reinforce ground potential and lower possibility of loss of signals transmitted through each signal line.

Here, the first ground conductor G1 positioned on the first inner wall surface 11K1 may be so-called castellation formed by application onto the first inner wall surface 11K1, or may have a shape formed by dividing of a so-called via that is formed by the first middle cutout part 11K being filled with metal paste. The second ground conductor G2 positioned on the second inner wall surface 2K1 may have the same and/or similar configuration as or to that of the first ground conductor G1.

As illustrated in FIG. 4, in an embodiment, the first middle cutout part 11K, the second middle cutout part 2K, and the middle through-conductor 2G1 are positioned in any identical straight line in plan view. With such a configuration, the pair of first signal lines S1 and the pair of second signal lines S2 can easily have the same grounding state, and impedance adjustment can be easier.

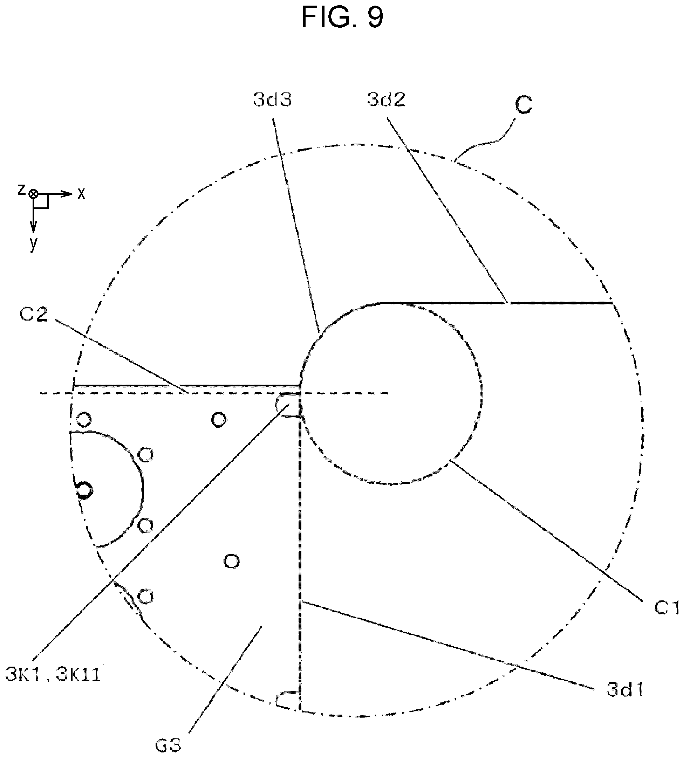

In the case in which the wiring board 101 further includes the third ground conductor G3, as illustrated in FIGs. 7 to 9, the third insulating layer 3 may include a third upper surface 3a, a third side surface 3b, a third lower surface 3c, an inner side-surface 3d, and an inner cutout part 3K1. The third lower surface 3c is positioned on an opposite side to the third upper surface 3a. The third side surface 3b couples the third upper surface 3a to the third lower surface 3c and is positioned on the same plane as the second side surface 2b. The inner side-surface 3d couples the third upper surface 3a to the third lower surface 3c and includes a fourth side surface 3d1 on an opposite side to the third side surface 3b. The inner side-surface 3d includes a lateral side-surface 3d2 in the first direction, and a corner part 3d3 between the lateral side-surface 3d2 and the fourth side surface 3d1. As illustrated in FIG. 9, the corner part 3d3 has an arc shape in plan view. The inner cutout part 3K1 may be cutout from the third upper surface 3a to the fourth side surface 3d1. The inner cutout part 3K1 includes a third inner wall surface 3K11 continuing to the corner part 3d3 and the fourth side surface 3d1. The third ground conductor G3 may be positioned on the third upper surface 3a and extend from the third upper surface 3a to on the third inner wall surface 3K11. Such a configuration can reinforce ground potential with less stress that occurs at the corner part 3d3 of the third insulating layer 3 when the wiring board 101 has a reduced size. More specifically, assuming that an imaginary circle along the corner part 3d3 is an imaginary circle C1, and a center line passing through a center point of the imaginary circle C1 and extending in the first direction (x-direction) is a center line C2, in plan view, in the third inner wall surface 3K11, at least a portion close to the lateral side-surface 3d2 matches the center line C2.

The inner cutout part 3K1 may further be cutout from the fourth side surface 3d1 to the third lower surface 3c. In this case, when the third insulating layer 3 includes the configuration in which multiple insulating layers are laminated on one another, the inner cutout part 3K1 can be formed by application of the same and/or similar punching processing to each insulating layer. Therefore, manufacturing of the wiring board 101 can be easier.

Here, the third ground conductor G3 positioned on the third inner wall surface 3K11 may be so-called castellation formed by application of metal paste onto the third inner wall surface 3K11, or may have a shape formed by dividing of a via that is formed by the third cutout part 3K1 being filled with metal paste.

### <Method for Manufacturing Wiring Board>

According to an embodiment of the present disclosure, a method for manufacturing the wiring board 101 is described. Note that the present disclosure is not limited to the following embodiment, but for example, a 3D printer may be used for manufacture.
(1) First, a plurality of green sheets is formed. Specifically, for example, a mixture is obtained by adding and mixing organic binder, plasticizer, a solvent, or the like to ceramic powder, such as boron nitride, aluminum nitride, silicon nitride, silicon carbide, beryllium oxide, or the like. Then, the mixture is formed to be layered to fabricate multiple green sheets. Next, the multiple green sheets are processed using a mold or the like to prepare multiple green sheets formed to have external shapes of the respective ones of the first insulating layer 1 and the second insulating layer 2 in plan view. Through-holes in external shapes of the respective ones of the middle through-conductor 2G1, the pair of first through-conductors 2S1, and the pair of second through-conductors 2S2 are provided to the second insulating layer 2 by using a mold, a laser, or the like. Note that in the case of forming the wiring board 101 including the third insulating layer 3, a green sheet formed to have an external shape of the third insulating layer 3 is additionally prepared. In the case in which the first insulating layer includes the first opening part 11O1 and the second opening part 1102, the first opening part 11O1 and the second opening part 1102 are provided by using a mold, a laser, or the like to the green sheet that becomes the first insulating layer 1.
(2) High-melting-point metal powder such as tungsten or molybdenum is prepared, and metal paste is prepared by adding and mixing organic binder, plasticizer, a solvent, or the like to the prepared powder. Next, the metal paste is printed in a given pattern on the multiple green sheets formed to have the external shapes of the respective ones of the first insulating layer 1, the second insulating layer 2, and the third insulating layer 3, to form the conductor layer S, the first ground conductor G1, and the second ground conductor G2. Note that the metal paste may include glass or ceramics to increase bonding strength with respect to each insulating layer.
(3) The through-holes provided to the second insulating layer 2 in the step (1) described above are filled with the metal paste to form the middle through-conductor 2G1, the pair of first through-conductors 2S1, and the pair of second through-conductors 2S2.
(4) The multiple green sheets formed to have the external shapes of the respective ones of the first insulating layer 1 and the second insulating layer 2 are stacked on one another in such a manner that outer edge portions of the multiple green sheets match one another. Thereby, a green sheet stacking body is formed. Note that the metal paste may be printed, after the formation of the green sheet stacking body, in a given pattern so as to then form the conductor layer S, the first ground conductor G1, the second ground conductor G2, and another wiring lines.
(5) The green sheet stacking body is fired to sinter the multiple green sheets, thus obtaining the wiring board 101.

### <Configuration of Electronic Component Mounting Package>

As illustrated in FIG. 1, in an embodiment, the electronic component mounting package 100 includes the wiring board 101, a substrate 102, and a frame body 103. The frame body 103 is bonded to an upper surface of the substrate 102, and the wiring board 101 is secured to the frame body 103. The wiring board 101 may be bonded to the upper surface of the substrate 102.

The substrate 102 includes the upper surface. For example, the substrate 102 has a quadrilateral shape in plan view, a size of 10 mm × 10 mm to 50 mm × 50 mm, and a thickness of 0.5 mm to 20 mm. Examples of a material for the substrate 102 include a metal material, such as copper, iron, tungsten, molybdenum, nickel, or cobalt, or an alloy containing these metal materials. In this case, the substrate 102 may be a single metal plate or a multilayer body including a plurality of laminated metal plates. In the case in which the material for the substrate 102 is the metal material described above, in order to reduce oxidation corrosion, a surface of the substrate 102 may be formed with a plating layer of nickel, gold, or the like, by using an electroplating method or an electroless plating method. A material for the substrate 102 may be an insulating material, for example, a ceramic material, such as an aluminum oxide-based sintered body, a mullite-based sintered body, a silicon carbide-based sintered body, an aluminum nitride-based sintered body, a silicon nitride-based sintered body, or glass ceramics.

The frame body 103 is positioned on the upper surface of the substrate 102 and protects an electronic component 104 positioned inside in plan view. That is, the frame body 103 surrounds the electronic component 104 when seen in plan view. As illustrated in FIG. 1, in an embodiment, the frame body 103 is not positioned at one side of an outer edge of the upper surface of the substrate 102. That is, the frame body 103 and the wiring board 101 surround the outer edge of the upper surface of the substrate 102. In other words, the frame body 103 and the wiring board 101 surround the electronic component 104. In this manner, the frame body 103 does not necessarily surround the entirety of the outer edge of the upper surface of the substrate 102. Although in an embodiment the frame body 103 is positioned along the outer edge of the upper surface of the substrate 102, it may be positioned at an inner side of the outer edge of the upper surface of the substrate 102.

A material for the frame body 103 may be, for example, a metal material, such as copper, iron, tungsten, molybdenum, nickel, or cobalt, or an alloy containing these metal materials. The material for the frame body 103 may be an insulating material, for example, a ceramic material, such as an aluminum oxide-based sintered body, a mullite-based sintered body, a silicon carbide-based sintered body, an aluminum nitride-based sintered body, a silicon nitride-based sintered body, or glass ceramics.

The frame body 103 may be bonded to the substrate 102 with a brazing material or the like interposed therebetween. Note that a material of the brazing material is, for example, silver, copper, gold, aluminum, or magnesium, and may contain an additive such as nickel, cadmium, or phosphorus.

### <Configuration of Electronic Module>

As illustrated in FIG. 1, the electronic module 10 includes the electronic component mounting package 100, the electronic component 104, and a lid body 106. The electronic module 10 may include a seal ring 105.

The electronic component 104 may be, for example, a component which performs signal processing, such as conversion of an optical signal into an electrical signal, or conversion of an electrical signal into an optical signal. The electronic component 104 is positioned on the upper surface of the substrate 102 and is accommodated in the electronic component mounting package 100.

Examples of the electronic component 104 include an optical semiconductor element, such as a semiconductor laser (LD: laser diode) or a photo diode (PD), a semiconductor integrated circuit element, and a sensor element such as an optical sensor. For example, the electronic component 104 can be formed by using a semiconductor material, such as gallium arsenide or gallium nitride.

The lid body 106 is positioned on the frame body 103 to cover an internal portion of the electronic component mounting package 100, and protects, together with the frame body 103, the electronic component 104. For example, the lid body 106 has a quadrilateral shape in plan view, a size of 10 mm × 10 mm to 50 mm × 50 mm, and a thickness of 0.5 mm to 2 mm. Examples of a material for the lid body 106 include a metal material, such as iron, copper, nickel, chromium, cobalt, molybdenum, or tungsten, or an alloy combining multiple materials among these metal materials. By application of metalworking such as rolling processing or punching processing to an ingot of such a metal material, the metal member which configures the lid body 106 can be fabricated.

The seal ring 105 has a function to bond the lid body 106 and the frame body 103. The seal ring 105 is positioned on the frame body 103 to surround the electronic component 104 in plan view. Examples of a material for the seal ring 105 include a metal material, such as iron, copper, silver, nickel, chromium, cobalt, molybdenum, or tungsten, or an alloy combining multiple materials among these metal materials. Note that in a case of not providing the seal ring 105 on the frame body 103, the lid body 106 may be bonded through a bonding material, such as solder, a brazing material, glass, or a resin adhesive material.

Note that various combinations of feature parts in an embodiment are not limited to the examples in the embodiments described above. The respective embodiments can be combined together.

### INDUSTRIAL APPLICABILITY

The present disclosure is applicable to a wiring board, an electronic component mounting package using a wiring board, and an electronic module.

### REFERENCE SIGNS

1 first insulating layer
1a first upper surface
1b first side surface
11 projecting part
11a first surface
11O1 first opening part
1102 second opening part
11K first middle cutout part
11K1 first inner wall surface
2 second insulating layer
2a second upper surface
2b second side surface
2c second lower surface
2S1a-b a pair of first through-conductors
2S2a-b a pair of second through-conductors
2G1 middle through-conductor
2K second middle cutout part
2K1 second inner wall surface
3 third insulating layer
3a third upper surface
3b third side surface
3c third lower surface
3d inner side-surface
3d1 fourth side surface
3d2 lateral side-surface
3d3 corner part
3K1 inner cutout part
3K11 third inner wall surface
3G3 third through-conductor
3G4 fourth through-conductor
C1 imaginary circle
C2 center line
S conductor layer
S1 a pair of first signal lines
S11 first line part
S12 first connection part
WS11 first line part width
WS12 first connection part width
S2 a pair of second signal lines
S21 second line part
S22 second connection part
WS21 second line part width
WS22 second connection part width
S3 first interlayer signal conductor
S4 second interlayer signal conductor
G1 first ground conductor
G2 second ground conductor
O1a-b a pair of first openings
O2a-b a pair of second openings
O3 a pair of third openings
O4 a pair of fourth openings
G3 third ground conductor
L1 distance between middle through-conductor and first through-conductor close thereto
L2 distance between middle through-conductor and second through-conductor close thereto
L3 distance between middle through-conductor and third through-conductor
L4 distance between middle through-conductor and fourth through-conductor
OL1 first opening dimension
OL2 second opening dimension
OL3 third opening dimension
OL4 fourth opening dimension
10 electronic module
100 electronic component mounting package
101 wiring board
102 substrate
103 frame body
104 electronic component
105 seal ring
106 lid body

## Claims

1. A wiring board comprising:
a first insulating layer comprising a first upper surface and a first side surface connected to the first upper surface;
a second insulating layer positioned on the first insulating layer and comprising a second upper surface, a second lower surface on an opposite side to the second upper surface, and a second side surface coupling the second upper surface to the second lower surface;
a conductor layer positioned on the first upper surface and comprising a pair of first signal lines and a pair of second signal lines, the pair of first signal lines and the pair of second signal lines transmitting differential signals and extending in a first direction;
a first ground conductor positioned on the first upper surface and between the pair of first signal lines and the pair of second signal lines with a gap between the first ground conductor and the pair of first signal lines and a gap between the first ground conductor and the pair of second signal lines; and
a second ground conductor positioned on the second upper surface and comprising a pair of first openings and a pair of second openings positioned side by side with the pair of first openings, wherein
the pair of second signal lines is positioned side by side with the pair of first signal lines,
the second insulating layer comprises a pair of first through-conductors, a pair of second through-conductors, and one or more middle through-conductors each penetrating from the second upper surface to the second lower surface,
each first through-conductor of the pair of first through-conductors is positioned in a corresponding one of the pair of first openings and electrically coupled to a corresponding one of the pair of first signal lines,
each second through-conductor of the pair of second through-conductors is positioned in a corresponding one of the pair of second openings and electrically coupled to a corresponding one of the pair of second signal lines, and
the middle through-conductor is positioned between the pair of first openings and the pair of second openings and electrically coupled to the first ground conductor and the second ground conductor, and the middle through-conductor is a ground through-conductor close to one first through-conductor of the pair of first through-conductors as well as a ground through-conductor close to one second through-conductor of the pair of second through-conductors in a second direction intersecting with the first direction.

2. The wiring board according to claim 1, further comprising a third insulating layer positioned on the second upper surface, wherein
the third insulating layer comprises a third through-conductor and a fourth through-conductor each penetrating the third insulating layer and electrically coupled to the **second** ground conductor,
the third through-conductor is positioned between the respective first openings of the pair of first openings,
the fourth through-conductor is positioned between the respective second openings of the pair of second openings, and
in the second direction,
the third through-conductor is a ground through-conductor close to each first through-conductor of the pair of first through-conductors, and
the fourth through-conductor is a ground through-conductor close to each second through-conductor of the pair of second through-conductors.

3. The wiring board according to claim 1 or 2, wherein each opening of the pair of first openings and the pair of second openings has a circular shape in plan view.

4. The wiring board according to claim 2 or 3, wherein the third through-conductor, the fourth through-conductor, and the middle through-conductor are positioned in a straight line in the second direction.

5. The wiring board according to any one of claims 2 to 4, wherein the pair of first through-conductors, the pair of second through-conductors, the third through-conductor, the fourth through-conductor, and the middle through-conductor are positioned in a straight line in the second direction.

6. The wiring board according to any one of claims 2 to 5, wherein, in plan view, when a distance in the second direction between the third through-conductor and the middle through-conductor is L3, and a distance in the second direction between the fourth through-conductor and the middle through-conductor is L4, L3 = L4 is satisfied.

7. The wiring board according to any one of claims 1 to 6, wherein, in plan view, the second ground conductor comprises a pair of third openings and a pair of fourth openings, each third opening of the pair of third openings overlapping a corresponding one of the pair of first signal lines, and each fourth opening of the pair of fourth openings overlapping a corresponding one of the pair of second signal lines.

8. The wiring board according to claim 7, wherein, in the second direction, when a dimension of each first opening of the pair of first openings is OL1, a dimension of each second opening of the pair of second openings is OL2, a dimension of each third opening of the pair of third openings is OL3, and a dimension of each fourth opening of the pair of fourth openings is OL4, OL1 ≥ OL3, and OL2 ≥ OL4 are satisfied.

9. The wiring board according to any one of claims 1 to 8, wherein the first insulating layer comprises a projecting part extending outward in the first direction from the second side surface of the second insulating layer in plan view and comprising the first side surface,
the projecting part comprises a first surface of the first upper surface of the first insulating layer, and a first opening part and a second opening part that open at the first surface, the first surface extending from the second side surface of the second insulating layer in the first direction,
the pair of first signal lines and the pair of second signal lines extend on the first surface of the projecting part,
the first opening part is positioned between the respective first signal lines of the pair of first signal lines, and
the second opening part is positioned between the respective second signal lines of the pair of second signal lines.

10. The wiring board according to claim 9, wherein
in plan view,
the respective first signal lines of the pair of first signal lines comprise first connection parts and first line parts extending inward in the first direction from the corresponding first connection parts,
the respective second signal lines of the pair of second signal lines comprise second connection parts and second line parts extending inward in the first direction from the corresponding second connection parts,
the first opening part is positioned between the first line parts constituting a pair, and
the second opening part is positioned between the second line parts constituting a pair, and
in the second direction,
a dimension of each first line part of the first line parts is shorter than a dimension of each first connection part of the first connection parts, and
a dimension of each second line part of the second line parts is shorter than a dimension of each second connection part of the second connection parts.

11. The wiring board according to claim 9 or 10, wherein the projecting part comprises a first middle cutout part cutout from the first surface to the first side surface,
the first middle cutout part comprises a first inner wall surface connected to the first surface and the first side surface and overlaps the middle through-conductor in side view in the first direction, and
the first ground conductor extends from on the first surface to on the first inner wall surface.

12. The wiring board according to any one of claims 1 to 11, wherein the second insulating layer comprises a second middle cutout part cutout from the second upper surface to the second side surface,
the second middle cutout part comprises a second inner wall surface connected to the second upper surface and the second side surface and overlaps the middle through-conductor in side view in the first direction, and
the second ground conductor extends from the second upper surface to on the second inner wall surface.

13. The wiring board according to any one of claims 2 to 12, further comprising a third ground conductor, wherein
the third insulating layer comprises:
a third upper surface;
a third lower surface on an opposite side to the third upper surface;
a third side surface coupling the third upper surface to the third lower surface and positioned on a same plane as the second side surface;
an inner side-surface coupling the third upper surface to the third lower surface and comprising a fourth side surface on an opposite side to the third side surface; and
an inner cutout part cutout from the third upper surface to the fourth side surface,
the inner side-surface comprises a lateral side-surface in the first direction, and a corner part between the lateral side-surface and the fourth side surface,
the corner part has an arc shape in plan view,
the inner cutout part comprises a third inner wall surface continuing to the corner part and the fourth side surface, and
the third ground conductor is positioned on the third upper surface and extends from the third upper surface to on the third inner wall surface.

14. An electronic component mounting package comprising:
a substrate;
a frame body bonded to an upper surface of the substrate; and
the wiring board according to any one of claims 1 to 13, the wiring board being secured to the frame body.

15. An electronic module comprising:
the electronic component mounting package according to claim 14;
an electronic component positioned on the upper surface of the substrate and electrically coupled to the wiring board of the electronic component mounting package; and
a lid body positioned on the frame body to cover an internal portion of the electronic component mounting package.
